# EUROPEAN PATENT SPECIFICATION

(11) **EP 4 276 895 B1**
(45) Date of publication and mention of the grant of the patent: **30.04.2025**
(21) Application number: 21929781.9
(22) Date of filing: 02.07.2021
(51) Int. Cl.: H10B 12/00, H01L 21/768

(54) **PREPARATION METHOD FOR SEMICONDUCTOR STRUCTURE, AND SEMICONDUCTOR STRUCTURE**
HERSTELLUNGSVERFAHREN FÜR EINE HALBLEITERSTRUKTUR UND HALBLEITERSTRUKTUR
PROCÉDÉ DE PRÉPARATION POUR STRUCTURE SEMI-CONDUCTRICE, ET STRUCTURE SEMI-CONDUCTRICE

(30) Priority: 12.03.2021 CN 202110269749
(43) Date of publication of application: 15.11.2023
(73) Proprietor: Changxin Memory Technologies, Inc., Hefei, Anhui 230601 (CN)
(72) Inventor: PING, Er-Xuan, Hefei, Anhui 230601 (CN); BAI, Jie, Hefei, Anhui 230601 (CN); HUANG, Juanjuan, Hefei, Anhui 230601 (CN)
(74) Representative: Gulde & Partner
(86) International application number: PCT/CN2021/104158
(87) International publication number: WO 2022/188311

(56) References cited:
- CN-A- 104 103 578
- US-A1- 2014 054 537
- US-A1- 2014 299 989
- US-A1- 2020 020 697
- US-A1- 2020 203 354
- US-A1- 2020 312 707
- US-A1- 2020 335 506

## Description

### CROSS-REFERENCE TO RELATED APPLICATION

This application claims the priority of Chinese Patent Application Serial No. 202110269749.6, filed with the State Intellectual Property Office of P. R. China on March 12, 2021, named "Method for manufacturing Semiconductor Structure and Semiconductor Structure'.

### TECHNICAL FIELD

The embodiments of the present disclosure relate to the technical field of semiconductor manufacturing, and particularly relate to a method for manufacturing a DRAM structure and the DRAM structure.

### BACKGROUND

With the gradual development of the storage device technology, a Dynamic Random-Access Memory (DRAM) is gradually applied to various electronic devices due to its higher density and faster reading and writing speed. The DRAM includes a bit line structure, a capacitor structure and a transistor structure. The bit line structure and the capacitor structure are respectively connected with the transistor structure. The data stored in the capacitor structure is read through the control of the transistor structure.

However, at present, the performance of the DRAM still needs to be improved. Related technologies are known from US 2014/299989 A1, US 2022/020697 A1 and US 2020/203354 A1.

### SUMMARY

The invention is set out in the appended set of claims.

### BRIEF DESCRIPTION OF THE DRAWINGS

In order to more clearly illustrate the technical solutions in the embodiments of the present disclosure or in the prior art, the drawings required for description in the embodiments or the prior art will be briefly described below. It is apparent that the drawings in the following description are some embodiments of the present disclosure. Those skilled in the art can also obtain other drawings according to these drawings without any creative work.
FIG. 1 is a flow diagram of a method for manufacturing a semiconductor structure provided by an embodiment of the present disclosure.
FIG. 2 is a schematic structural diagram after a mask layer is formed in a method for manufacturing a semiconductor structure provided by an embodiment of the present disclosure.
FIG. 3 is a schematic structural diagram after grooves are formed in a method for manufacturing a semiconductor structure provided by an embodiment of the present disclosure.
FIG. 4 is a schematic structural diagram after insulation sealing layers are formed in a method for manufacturing a semiconductor structure provided by an embodiment of the present disclosure.
FIG. 5 is a schematic structural diagram of a semiconductor structure provided by an embodiment of the present disclosure.

### DETAILED DESCRIPTION

In order to make the objectives, technical solutions and advantages of the embodiments of the present disclosure clearer, the technical solutions in the embodiments of the present disclosure will be clearly and completely described below with reference to the drawings in the embodiments of the present disclosure. It is apparent that the described embodiments are a part of the embodiments of the present disclosure, but are not all of the embodiments. Based on the embodiments in the present disclosure, all other embodiments obtained by those skilled in the art without creative efforts fall within the protection scope of the present disclosure.

This embodiment provides a method for manufacturing a DRAM structure and the DRAM structure to improve the performance of the semiconductor structure.

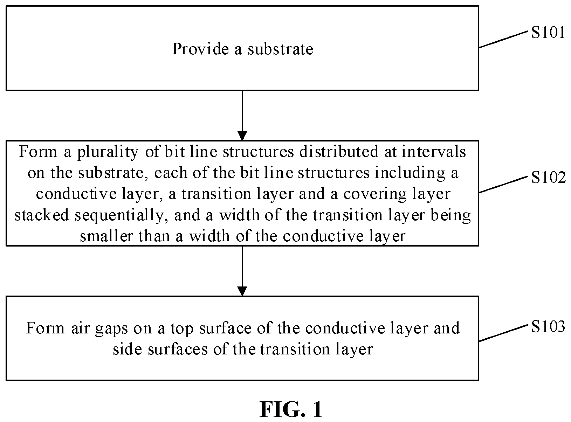

As shown in FIG. 1, the method for manufacturing the semiconductor structure provided in this embodiment includes:

In S101, a substrate is provided.

The substrate serves as the basis of a subsequent film layer and can achieve a support effect on the subsequent film layer. Exemplarily, the material of the substrate can be a semiconductor material, including silicon, germanium, silicon germanium, etc. This embodiment does not limit the material of the substrate.

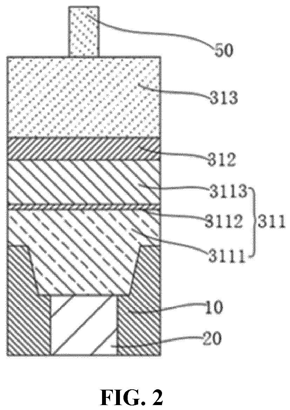

Referring to FIG. 2 to FIG. 5, shallow trench isolation structures 10 and active region structures 20 arranged at intervals can be formed on the substrate (not shown), so as to facilitate the formation of a transistor structure.

After the substrate is formed, the method for manufacturing the semiconductor structure provided in this embodiment further includes:

In S102, a plurality of bit line structures distributed at intervals are formed on the substrate, each of the bit line structures includes a conductive layer, a transition layer and a covering layer stacked sequentially, and the width of the transition layer is smaller than the width of the conductive layer.

Continuing to refer to FIG. 2 to FIG. 5, a conductive layer 301, a transition layer 302 and a covering layer 3031 are stacked, the transition layer 302 is located between the covering layer 3031 and the conductive layer 301, and the conductive layer 301 is arranged close to the substrate. According to the claimed invention, the conductive layer 301 is connected with an active structure 20. Exemplarily, the conductive layer 301 can be connected with a source electrode or a gate electrode of the active structure 20.

The specific steps of forming the conductive layer 301 can include: as shown in FIG. 2, a conductive initial layer 311 is formed. Exemplarily, a first conductive initial layer 3111, a conductive contact initial layer 3112 and a second conductive initial layer 3113 are sequentially stacked along a direction distal from the substrate. The conductive contact initial layer 3112 is located between the first conductive initial layer 3111 and the second conductive initial layer 3113. The conductive contact initial layer 3112 can prevent the materials constituting the first conductive initial layer 3111 and the second conductive initial layer 3113 from permeating, and can also reduce the contact resistance between the first conductive initial layer 3111 and the second conductive initial layer 3113. Exemplarily, the material of the first conductive initial layer 3111 can include polysilicon, the material of the second conductive initial layer 3113 can include tungsten, and the material of the conductive contact initial layer 3112 can include titanium nitride or tungsten nitride.

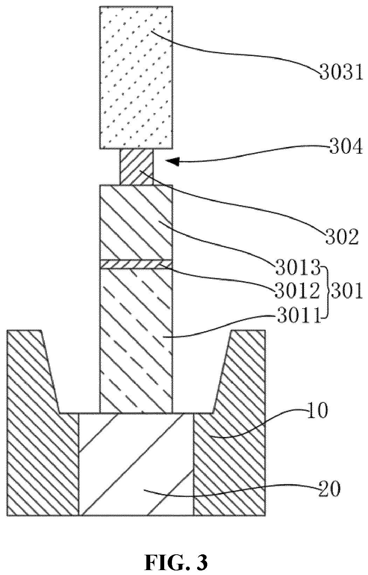

According to the claimed invention, the width of the transition layer 302 is smaller than the width of the conductive layer 301 (taking the orientation shown in FIG. 3 as an example, the width is a size in a horizontal direction). After the conductive initial layer 311 is formed, a transition initial layer 312 and a covering initial layer 313 which are stacked are formed, and a mask layer 50 having a mask pattern is formed on the covering initial layer 313. As shown in FIG. 3, then the covering initial layer 313, the transition initial layer 312 and the conductive initial layer 311 are etched by taking the mask layer 50 as a mask, so as to form the covering layer 3031, the transition layer 302 and the conductive layer 301. At this time, the covering layer 3031, the transition layer 302 and the conductive layer 301 have the same width. After that, the transition layer 302 is etched horizontally to remove a portion of the transition layer 302 to form grooves 304, such that the width of the finally formed transition layer 302 is smaller than the width of the conductive layer 301. Exemplarily, a portion of the transition layer 302 can be removed by a wet process. In other examples, when the covering initial layer 313, the transition initial layer 312 and the conductive initial layer 311 are etched by taking the mask layer 50 as a mask, a portion of the transition initial layer 312 that is partially located below the covering layer 3031 is etched simultaneously, such that the width of the formed transition layer 302 is smaller than the width of the conductive layer 301. Exemplarily, when the transition initial layer 312 is etched, the gas with a higher etching selection ratio of the transition initial layer 312 to the conductive initial layer 311 and the covering initial layer 313 can be selected for etching, and then, a portion of the transition initial layer 312 below the covering layer 3031 is etched along a width direction, such that the width of the finally formed transition layer 302 is smaller than the width of the conductive layer 301.

In this embodiment, a plurality of bit line structures 30 are distributed at intervals. Exemplarily, a plurality of bit line structures 30 extend in a line shape along a direction parallel to the substrate, a plurality of bit line structures 30 can be located in the same plane parallel to the substrate, and a plurality of bit line structures 30 are arranged in parallel and at intervals. Of course, the bit line structures 30 in this embodiment can also be distributed on the substrate in other forms, which is not limited in this embodiment.

After a plurality of bit line structures 30 distributed at intervals are formed, the method for manufacturing the semiconductor structure provided in this embodiment further includes:

In S103, air gaps are formed on the top surface of the conductive layer and the side surfaces of the transition layer.

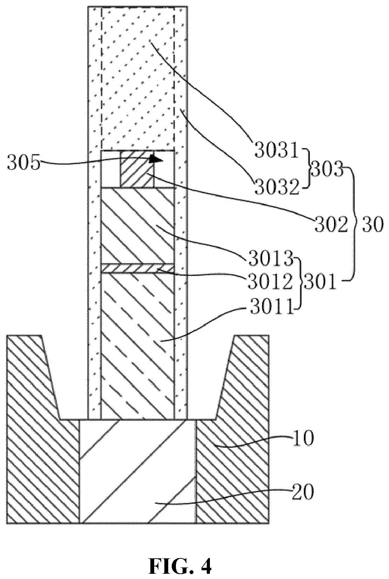

As shown in FIG. 4 to FIG. 5, according to the claimed invention, the width of the transition layer 302 in the bit line structure 30 is smaller than the width of the conductive layer 301, such that the bit line structure 30 forms grooves 304 on two sides of the transition layer 302 along a width direction. In order to form air gaps 305, the bit line structure 30 can include insulation sealing layers 3032 covering the side walls of the conductive layer 301 and the side walls of the covering layer 3031. At this time, the insulation sealing layers 3032 seal the grooves 304 to form the air gaps 305 located on two sides of the transition layer 302 along the width direction.

Exemplarily, the insulation sealing layers 3032 can be formed by CVD or ALD, and the grooves 304 are prevented from being filled with the insulation sealing layers 3032 at the same time, such that the air gaps 305 are enclosed by the insulation sealing layers 3032, the conductive layer 301, the transition layer 302 and the covering layer 3031.

Exemplarily, the material of the insulation sealing layer 3032 can be the same as the material of the covering layer 3031. For example, the material of both the insulation sealing layer 3032 and the covering layer 3031 can be silicon nitride, silicon oxide, etc. Since the material of the insulation sealing layer 3032 is the same as the material of the covering layer 3031, after the insulation sealing layers 3032 are formed, the covering layer 3031 and the insulation sealing layers 3032 can be formed into an integrated structure to improve the strength of a coating layer 303.

According to the method for manufacturing the semiconductor structure provided in this embodiment, a plurality of bit line structures 30 are distributed on the substrate, each of the bit line structures 30 includes a conductive layer 301, a transition layer 302 and a covering layer 3031 stacked sequentially, the width of the transition layer 302 is smaller than the width of the conductive layer 301, and the air gaps 305 are formed on the top surface of the conductive layer 301 and the side surfaces of the transition layer 302. By forming the air gaps 305 on the top surface of the conductive layer 301 and the side surfaces of the transition layer 302, the influence of the covering layer 3031 on the conductive layer 301 is reduced. For example, when the material of the covering layer 3031 is silicon nitride and the material of the conductive layer 301 is tungsten, the existence of the air gaps 305 can reduce the degree to which nitrogen in the covering layer 3031 migrates to the conductive layer 301 to nitride the conductive layer 301 to form tungsten nitride so as to prevent the resistance of the conductive layer 301 from increasing, and also can reduce the parasitic capacitance between the bit line structures 30 and the surrounding structures thereof, thereby improving the performance of the semiconductor structure.

In some embodiments, the width of the covering layer 3031 can be greater than the width of the conductive layer 301, and the formed air gaps 305 can protrude from the side surfaces of the conductive layer 301. By such arrangement, the contact area between the air gaps 305 and the top surface of the conductive layer 301 can be increased to improve the protective effect on the top surface of the conductive layer 301. At the same time, the volume of the air gaps 305 can be increased to further improve the parasitic capacitance between the bit line structures 30 and the surrounding structures (such as conductive plugs 40).

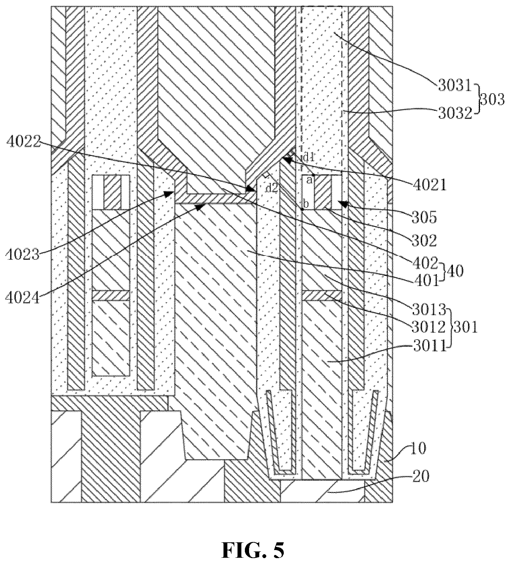

Continuing to refer to FIG. 5, the method for manufacturing the semiconductor structure provided in this embodiment further includes: a conductive plug 40 is formed on the substrate between the bit line structures 30, the conductive plug 40 is located between adjacent bit line structures 30, and the conductive plug 40 is used to connect the active region structure 20. According to the claimed invention, the conductive plug 40 is also used to connect a capacitor storage structure.

Exemplarily, the conductive plug 40 includes a first conductive portion 401 and a second conductive portion 402 which are sequentially stacked along a direction perpendicular to the substrate. In other words, the second conductive portion 402 is located over the first conductive portion 401, the first conductive portion 401 is connected with the active region structure 20, and the second conductive portion 402 can be used to connect a capacitor. Exemplarily, the material of the first conductive portion 401 can include polysilicon, etc., and the material of the second conductive portion 402 can include tungsten, etc. In order to prevent the materials of the first conductive portion 401 and the second conductive portion 402 from permeating each other, a conductive barrier film can be arranged between the first conductive portion 401 and the second conductive portion 402. The material of the conductive barrier film can include titanium nitride, etc.

The bottom portion of the second conductive portion 402 has an inclined surface 4021 facing the bit line structure 30.

According to the claimed invention, the bottom of the inclined surface 4021 is higher than the top of the conductive layer 301, and the top of the inclined surface 4021 is lower than the top of the transition layer 302, such that the top of the transition layer 302 is located between the top and bottom of the inclined surface 4021. At this time, the formed conductive layer 301 can be as high as possible and has smaller resistance.

Exemplarily, the bottom portion of the second conductive portion 402 further includes a bottom surface 4024, a first straight surface 4022 and a second straight surface 4023. The bottom surface 4024 is in direct contact with the top surface of the first conductive portion 401, and two ends of the bottom surface 4024 are respectively connected with the first straight surface 4022 and the second straight surface 4023. The first straight surface 4022 is also connected with the inclined surface 4021.

According to the claimed invention, the vertical distance between the top corner of the transition layer 302 and the inclined surface 4021 is smaller than the vertical distance between the top corner of the conductive layer 301 and the inclined surface 4021. The top corner of the transition layer 302 is a first vertex a of the top end of the transition layer 302 close to the inclined surface 4021 in a cross section perpendicular to the substrate and perpendicular to the extension direction of the bit line structure 30 (in the cross section as shown in FIG. 5). The vertical distance between the top corner of the transition layer 302 and the inclined surface 4021 is a vertical distance d1 between the first vertex a and the inclined surface 4021. Correspondingly, the top corner of the conductive layer 301 is a second vertex b of the top end of the conductive layer 301 close to the inclined surface 4021 in a cross section perpendicular to the substrate and perpendicular to the extension direction of the bit line structure 30 (in the cross section as shown in FIG. 5). The vertical distance between the top corner of the conductive layer 301 and the inclined surface 4021 is a vertical distance d2 between the second vertex b and the inclined surface 4021.

In other examples not forming part of the claimed invention, the vertical distance d1 between the top corner of the transition layer 302 and the inclined surface 4021 is greater than the vertical distance d2 between the top corner of the conductive layer 301 and the inclined surface 4021. By such arrangement, when the transition layer 302 is a conductor, the resistance of the bit line structure 30 can be reduced, and the parasitic capacitance between the bit line structure 30 and the conductive plug 40 can also be further reduced.

In some embodiments, the width of the transition layer 302 is 2/3 to 3/4 of the width of the conductive layer 301. Such arrangement can reduce the influence of the covering layer 3031 on the conductive layer 301, ensure the supporting force for the covering layer 3031, and avoid the covering layer 3031 collapsing due to a too small width of the transition layer 302.

The material of the transition layer 302 provided in this embodiment can include metal-rich nitride (such as tungsten nitride, molybdenum nitride, titanium nitride, etc.) or metal-rich silicide (such as titanium silicide, tungsten silicide, etc.). By such arrangement, the metal-rich nitride and the metal-rich silicide can capture nitrogen atoms migrated from the covering layer 3031 to the conductive layer 301, so as to further avoid the influence of the conductive layer 301 on the covering layer 3031 to prevent the resistance of the conductive layer 301 from increasing. Exemplarily, the metal-rich nitride means that the molar ratio of metal atoms to nitrogen atoms is greater than 1, such as 2, 3, 4, 5, 6, 7, etc., and the metal-rich silicide means that the molar ratio of metal atoms to silicon atoms is greater than 1, such as 2, 3, 4, 5, 6, 7, etc.

Continuing to refer to FIG. 5, this embodiment further provides a DRAM structure which can be manufactured by the method for manufacturing the semiconductor structure provided by any one of the above embodiments. Each of the bit line structures of the semiconductor structure includes a conductive layer 301, a transition layer 302 and a covering layer 3031 stacked sequentially. The width of the transition layer 302 is smaller than the width of the conductive layer 301, and air gaps 305 are formed on the top surface of the conductive layer 301 and the side surfaces of the transition layer 302. The transition layer 302 and the air gaps 305 reduce the influence of the covering layer 3031 on the conductive layer 301 to prevent the resistance of the conductive layer 301 from increasing, thereby improving the performance of the semiconductor structure.

The semiconductor structure provided in this embodiment includes a substrate and a plurality of bit line structures distributed at intervals on the substrate. Each of the bit line structures includes a conductive layer 301, a transition layer 302 and a covering layer 3031 stacked sequentially. The width of the transition layer 302 is smaller than the width of the conductive layer 301.

Exemplarily, the material of the substrate can include silicon, germanium, silicon germanium, etc. The material of the substrate is not limited in this embodiment. Shallow trench isolation structures 10 and active region structures 20 arranged at intervals can be formed on the substrate, so as to facilitate the formation of a transistor structure.

The conductive layer 301, the transition layer 302 and the covering layer 3031 are stacked, the transition layer 302 is located between the covering layer 3031 and the conductive layer 301, and the conductive layer 301 is arranged close to the substrate. The conductive layer 301 can include a first conductive layer 3011, a conductive contact layer 3012 and a second conductive layer 3013 which are sequentially stacked along a direction distal from the substrate. The conductive contact layer 3012 is located between the first conductive layer 3011 and the second conductive layer 3013, and the conductive contact layer 3012 can prevent the materials constituting the first conductive layer 3011 and the second conductive layer 3013 from permeating. Exemplarily, the material of the first conductive layer 3011 can include polysilicon, the material of the second conductive layer 3013 can include tungsten, and the material of the conductive contact layer 3012 can include titanium nitride.

In this embodiment, a plurality of bit line structures are distributed at intervals. Exemplarily, a plurality of bit line structures extend in a line shape along a direction parallel to the substrate, a plurality of bit line structures can be located in the same plane parallel to the substrate, and a plurality of bit line structures are arranged in parallel and at intervals. Of course, the bit line structures in this embodiment can also be distributed on the substrate in other forms, which is not limited in this embodiment.

Continuing to refer to FIG. 5, the air gaps 305 are located on the top surface of the conductive layer 301 and the side surfaces of the transition layer 302. In other words, the air gaps 305 are formed between the side surfaces of the transition layer 302 and the top surface of the conductive layer 301.

In some implementation manners, a coating layer 303 can include a covering layer 3031 located at the upper portion of the transition layer 302 and insulation sealing layers 3032 covering the side walls of the covering layer 3031 and the side walls of the conductive layer 301. Since the width of the transition layer 302 is smaller than the width of the conductive layer 301, grooves can be formed on two sides of the transition layer 302. After the insulation sealing layers are formed, the insulation sealing layers 3032 cover the grooves to form the air gaps 305.

In some embodiments, the width of the covering layer 3031 is greater than the width of the conductive layer 301.

In some embodiments, the air gaps 305 protrude from the side surfaces of the conductive layer 301, that is, the air gaps 305 protrude outward from the side surfaces of the conductive layer 301. By such arrangement, the contact area between the air gaps 305 and the top surface of the conductive layer 301 can be increased to improve the protection effect on the top surface of the conductive layer 301. At the same time, the volume of the air gaps 305 can be increased to further improve the parasitic capacitance between the bit line structures 30 and the surrounding structures (such as conductive plugs 40).

Continuing to refer to FIG. 5, the semiconductor structure provided in this embodiment further includes conductive plugs 40 located between the bit line structures, each of the conductive plugs 40 is located between adjacent bit line structures 30, and the conductive plug 40 is used to connect the active region structure 20. According to the claimed invention, the conductive plug 40 is also used to connect a capacitor storage structure.

Exemplarily, the conductive plug 40 includes a first conductive portion 401 and a second conductive portion 402 which are sequentially stacked along a direction perpendicular to the substrate. In other words, the second conductive portion 402 is located over the first conductive portion 401, the first conductive portion 401 is connected with the active region structure 20, and the second conductive portion 402 is used to connect a capacitor storage structure. Exemplarily, the material of the first conductive portion 401 can include polysilicon, etc., and the material of the second conductive portion 402 can include tungsten, etc. In order to prevent the materials of the first conductive portion 401 and the second conductive portion 402 from permeating each other, a conductive barrier film can be arranged between the first conductive portion 401 and the second conductive portion 402. The material of the conductive barrier film can include titanium nitride, etc.

The bottom portion of the second conductive portion 402 has an inclined surface 4021 facing the bit line structure 30, and the bottom of the inclined surface 4021 is higher than the top of the conductive layer 301 and lower than the top of the transition layer 302, such that the top of the transition layer 302 is located between the top and bottom of the inclined surface 4021.

Exemplarily, the bottom portion of the second conductive portion further includes a bottom surface 4024, a first straight surface 4022 and a second straight surface 4023. The bottom surface 4024 is in direct contact with the top surface of the first conductive portion 401, and two ends of the bottom surface 4024 are respectively connected with the first straight surface 4022 and the second straight surface 4023. The first straight surface 4022 is also connected with the inclined surface 4021. By the arrangement of the first straight surface 4022 and the second straight surface 4023, the distance between the transition layer 302 and the second conductive portion 402 of the conductive plug 40 can be further increased to reduce the parasitic capacitance between the two, and at the same time, short circuit defects can be reduced to improve the yield.

According to the claimed invention, the vertical distance between the top corner of the transition layer 302 and the inclined surface 4021 is smaller than the vertical distance between the top corner of the conductive layer 301 and the inclined surface 4021. The top corner of the transition layer 302 is a first vertex a of the top end of the transition layer 302 close to the inclined surface 4021 in a cross section perpendicular to the substrate and perpendicular to the extension direction of the bit line structure 30 (in the cross section as shown in FIG. 5). The vertical distance between the top corner of the transition layer 302 and the inclined surface 4021 is a vertical distance d1 between the first vertex a and the inclined surface 4021. Correspondingly, the top corner of the conductive layer 301 is a second vertex b of the top end of the conductive layer 301 close to the inclined surface 4021 in a cross section perpendicular to the substrate and perpendicular to the extension direction of the bit line structure 30 (in the cross section as shown in FIG. 5). The vertical distance between the top corner of the conductive layer 301 and the inclined surface 4021 is a vertical distance d2 between the second vertex b and the inclined surface 4021.

In other examples not forming part of the claimed invention, the vertical distance d1 between the top corner of the transition layer 302 and the inclined surface 4021 is greater than the vertical distance d2 between the top corner of the conductive layer 301 and the inclined surface 4021. By such arrangement, when the transition layer 302 is a conductor, the resistance of the bit line structure 30 can be reduced, and the parasitic capacitance between the bit line structure 30 and the conductive plug 40 can also be further reduced.

In some embodimnets, the width of the transition layer 302 is 2/3 to 3/4 of the width of the conductive layer 301. Such arrangement can reduce the influence of the covering layer 3031 on the conductive layer 301, ensure the supporting force for the covering layer 3031, and avoid the covering layer 3031 collapsing due to a too small width of the transition layer 302.

The material of the transition layer 302 provided in this embodiment can include metal-rich nitride (such as tungsten nitride, molybdenum nitride, titanium nitride, etc.) or metal-rich silicide (such as titanium silicide, tungsten silicide, etc.). By such arrangement, the metal-rich nitride and the metal-rich silicide can capture nitrogen atoms migrated from the covering layer 3031 to the conductive layer 301, so as to further reduce the influence of the conductive layer 301 on the covering layer 3031 to prevent the resistance of the conductive layer 301 from increasing. For example, the material of the covering layer 3031 can include silicon nitride, etc.

## Claims

1. A method for manufacturing a DRAM structure, comprising:
providing (S101) a substrate;
forming (S102) a plurality of bit line structures (30) distributed at intervals on the substrate, each of the bit line structures comprising a conductive layer (301), a transition layer (302) and a covering layer (3031) stacked sequentially, and a width of the transition layer being smaller than a width of the conductive layer, the conductive layer being connected with an active structure (20) of a transistor structure;
forming (S103) air gaps (305) on a top surface of the conductive layer and side surfaces of the transition layer; and
forming a conductive plug (40) comprising a first conductive portion (401) and a second conductive portion (402) on the substrate between the bit line structures, and forming the second conductive portion over the first conductive portion, the conductive plug configured to be connected to a capacitor storage structure,
**characterized in that**
a bottom portion of the second conductive portion has an inclined surface (4021) facing the bit line structure,
a vertical distance between a top corner of the transition layer and the inclined surface is smaller than a vertical distance between a top corner of the conductive layer and the inclined surface, and
a bottom of the inclined surface is higher than a top of the conductive layer and lower than a top of the transition layer.

2. The method for manufacturing the DRAM structure of claim 1, wherein a width of the covering layer is greater than the width of the conductive layer, and the air gaps protrude from the side surfaces of the conductive layer.

3. The method for manufacturing the DRAM structure of claim 1, wherein
the bottom portion of the second conductive portion further comprises a bottom surface, a first straight surface and a second straight surface, wherein the bottom surface is in direct contact with a top surface of the first conductive portion, and two ends of the bottom surface are respectively connected with the first straight surface and the second straight surface; and
the first straight surface is also connected with the inclined surface.

4. A DRAM structure, comprising:
a substrate;
a plurality of bit line structures (30) distributed at intervals on the substrate, each of the bit line structures (30) comprising a conductive layer (301), a transition layer (302) and a covering layer (3031) stacked sequentially, and a width of the transition layer (302) being smaller than a width of the conductive layer (301), the conductive layer (301) being connected with an active structure (20) of a transistor structure;
air gaps (305) located on a top surface of the conductive layer (301) and side surfaces of the transition layer (302);
conductive plugs (40) located on the substrate between the bit line structures (30), each of the conductive plugs (40) comprising a first conductive portion (401) and a second conductive portion (402) located over the first conductive portion (401), the conductive plug (40) configured to be connected to a capacitor storage structure,
**characterized in that**
a bottom portion of the second conductive portion (402) has an inclined surface (4021) facing the bit line structure (30),
a vertical distance between a top corner of the transition layer (302) and the inclined surface (4021) is smaller than a vertical distance between a top corner of the conductive layer (301) and the inclined surface,
a bottom of the inclined surface (4021) is higher than a top of the conductive layer (301) and lower than a top of the transition layer (302).

5. The DRAM structure of claim 4, wherein a width of the covering layer (3031) is greater than a width of the conductive layer (301).

6. The DRAM structure of claim 4, wherein the air gaps (305) protrude from the side surfaces of the conductive layer (301).

7. The DRAM structure of claim 4, wherein
the bottom portion of the second conductive portion (402) further comprises a bottom surface (4024), a first straight surface (4022) and a second straight surface (4023), wherein the bottom surface (4024) is in direct contact with the first conductive portion (401), and two ends of the bottom surface (4024) are respectively connected with the first straight surface (4022) and the second straight surface (4023); and
the first straight surface (4022) is also connected with the inclined surface (4021).

8. The DRAM structure of claim 4, wherein a width of the transition layer (302) is 2/3 to 3/4 of a width of the conductive layer (301).

9. The DRAM structure of claim 4, wherein a material of the transition layer (302) comprises metal-rich nitride or metal-rich silicide, a material of the covering layer (3031) comprises silicon nitride, the metal-rich nitride means that the molar ratio of metal atoms to nitrogen atoms is greater than 1, and the metal-rich silicide means that the molar ratio of metal atoms to silicon atoms is greater than 1.

## Patentansprüche

1. Verfahren zum Herstellen einer DRAM-Struktur, umfassend:
Bereitstellen (S101) eines Substrats;
Ausbilden (S102) einer Vielzahl von Bitleitungsstrukturen (30), die in Intervallen auf dem Substrat verteilt sind, wobei jede der Bitleitungsstrukturen eine leitende Schicht (301), eine Übergangsschicht (302) und eine Deckschicht (3031) umfasst, die sequentiell gestapelt sind, und wobei eine Breite der Übergangsschicht kleiner als eine Breite der leitenden Schicht ist, wobei die leitende Schicht mit einer aktiven Struktur (20) einer Transistorstruktur verbunden ist;
Ausbilden (S103) von Luftspalten (305) auf einer oberen Fläche der leitenden Schicht und Seitenflächen der Übergangsschicht; und
Ausbilden eines leitenden Steckers (40), der einen ersten leitenden Abschnitt (401) und einen zweiten leitenden Abschnitt (402) auf dem Substrat zwischen den Bitleitungsstrukturen umfasst, und Ausbilden des zweiten leitenden Abschnitts über dem ersten leitenden Abschnitt, wobei der leitende Stecker konfiguriert ist, um mit einer Kondensatorspeicherstruktur verbunden zu werden,
**dadurch gekennzeichnet, dass**
ein unterer Abschnitt des zweiten leitenden Abschnitts eine geneigte Fläche (4021) aufweist, die der Bitleitungsstruktur zugewandt ist,
ein vertikaler Abstand zwischen einer oberen Ecke der Übergangsschicht und der geneigten Fläche kleiner ist als ein vertikaler Abstand zwischen einer oberen Ecke der leitenden Schicht und der geneigten Fläche, und
eine Unterseite der geneigten Fläche höher ist als eine Oberseite der leitenden Schicht und niedriger als eine Oberseite der Übergangsschicht.

2. Verfahren zum Herstellen der DRAM-Struktur nach Anspruch 1, wobei eine Breite der Deckschicht größer ist als die Breite der leitenden Schicht und die Luftspalte von den Seitenflächen der leitenden Schicht vorstehen.

3. Verfahren zum Herstellen der DRAM-Struktur nach Anspruch 1, wobei
der untere Abschnitt des zweiten leitenden Abschnitts ferner eine Unterseite, eine erste gerade Fläche und eine zweite gerade Fläche umfasst, wobei die Unterseite in direktem Kontakt mit einer oberen Fläche des ersten leitenden Abschnitts steht und zwei Enden der Unterseite jeweils mit der ersten geraden Fläche und der zweiten geraden Fläche verbunden sind; und
die erste gerade Fläche ebenfalls mit der geneigten Fläche verbunden ist.

4. DRAM-Struktur, umfassend:
ein Substrat;
eine Vielzahl von Bitleitungsstrukturen (30), die in Intervallen auf dem Substrat verteilt sind, wobei jede der Bitleitungsstrukturen (30) eine leitende Schicht (301), eine Übergangsschicht (302) und eine Deckschicht (3031) umfasst, die sequentiell gestapelt sind, und wobei eine Breite der Übergangsschicht (302) kleiner als eine Breite der leitenden Schicht (301) ist, wobei die leitende Schicht (301) mit einer aktiven Struktur (20) einer Transistorstruktur verbunden ist;
Luftspalte (305), die sich auf einer oberen Fläche der leitenden Schicht (301) und auf Seitenflächen der Übergangsschicht (302) befinden;
leitende Stecker (40), die auf dem Substrat zwischen den Bitleitungsstrukturen (30) angeordnet sind, wobei jeder der leitenden Stecker (40) einen ersten leitenden Abschnitt (401) und einen zweiten leitenden Abschnitt (402) umfasst, der über dem ersten leitenden Abschnitt (401) angeordnet ist, wobei der leitende Stecker (40) konfiguriert ist, um mit einer Kondensatorspeicherstruktur verbunden zu werden,
**dadurch gekennzeichnet, dass**
ein unterer Abschnitt des zweiten leitenden Abschnitts (402) eine geneigte Fläche (4021) aufweist, die der Bitleitungsstruktur (30) zugewandt ist,
ein vertikaler Abstand zwischen einer oberen Ecke der Übergangsschicht (302) und der geneigten Fläche (4021) kleiner ist als ein vertikaler Abstand zwischen einer oberen Ecke der leitenden Schicht (301) und der geneigten Fläche,
eine Unterseite der geneigten Fläche (4021) höher ist als eine Oberseite der leitenden Schicht (301) und niedriger als eine Oberseite der Übergangsschicht (301).

5. DRAM-Struktur nach Anspruch 4, wobei eine Breite der Deckschicht (3031) größer ist als die Breite der leitenden Schicht (301).

6. DRAM-Struktur nach Anspruch 4, wobei die Luftspalte (305) von den Seitenflächen der leitenden Schicht (301) vorstehen.

7. DRAM-Struktur nach Anspruch 4, wobei
der untere Abschnitt des zweiten leitenden Abschnitts (402) ferner eine Unterseite (4024), eine erste gerade Fläche (4022) und eine zweite gerade Fläche (4023) umfasst, wobei die Unterseite (4024) in direktem Kontakt mit dem ersten leitenden Abschnitt (401) steht und zwei Enden der Unterseite (4024) jeweils mit der ersten geraden Fläche (4022) und der zweiten geraden Fläche (4023) verbunden sind; und
die erste gerade Fläche (4022) ebenfalls mit der geneigten Fläche (4021) verbunden ist.

8. DRAM-Struktur nach Anspruch 4, wobei eine Breite der Übergangsschicht (302) 2/3 bis 3/4 einer Breite der leitenden Schicht (301) beträgt.

9. DRAM-Struktur nach Anspruch 4, wobei ein Material der Übergangsschicht (302) metallreiches Nitrid oder metallreiches Silizid umfasst, ein Material der Deckschicht (3031) Siliziumnitrid umfasst, wobei das metallreiche Nitrid bedeutet, dass das Molverhältnis von Metallatomen zu Stickstoffatomen größer als 1 ist, und das metallreiche Silizid bedeutet, dass das Molverhältnis von Metallatomen zu Siliziumatomen größer als 1 ist.

## Revendications

1. Procédé de fabrication d'une structure DRAM, comprenant :
fournir (S101) un substrat ;
former (S102) une pluralité de structures de lignes de bits (30) réparties à intervalles sur le substrat, chacune des structures de lignes de bits comprenant une couche conductrice (301), une couche de transition (302) et une couche de recouvrement (3031) empilées séquentiellement, et une largeur de la couche de transition étant inférieure à une largeur de la couche conductrice, la couche conductrice étant connectée à une structure active (20) d'une structure de transistor ;
former (S103) des entrefers (305) sur une surface supérieure de la couche conductrice et sur les surfaces latérales de la couche de transition ; et
former une fiche conductrice (40) comprenant une première partie conductrice (401) et une seconde partie conductrice (402) sur le substrat entre les structures de lignes de bits, et former la seconde partie conductrice sur la première partie conductrice, la fiche conductrice étant configurée pour être connectée à une structure de stockage de condensateur,
**caractérisé en ce qu'**
une partie inférieure de la seconde partie conductrice présente une surface inclinée (4021) faisant face à la structure de lignes de bits,
une distance verticale entre un coin supérieur de la couche de transition et la surface inclinée est inférieure à une distance verticale entre un coin supérieur de la couche conductrice et la surface inclinée, et
une partie inférieure de la surface inclinée est plus haut qu'un haut de la couche conductrice et plus bas qu'un haut de la couche de transition.

2. Procédé de fabrication de la structure DRAM de la revendication 1, dans lequel une largeur de la couche de recouvrement est supérieure à la largeur de la couche conductrice, et les entrefers font saillie à partir des surfaces latérales de la couche conductrice.

3. Procédé de fabrication de la structure DRAM de la revendication 1, dans lequel
la partie inférieure de la seconde partie conductrice comprend en outre une surface inférieure, une première surface droite et une seconde surface droite, la surface inférieure étant en contact direct avec une surface supérieure de la première partie conductrice, et deux extrémités de la surface inférieure étant respectivement reliées à la première surface droite et à la seconde surface droite ; et
la première surface droite est également reliée à la surface inclinée.

4. Structure DRAM, comprenant :
un substrat ;
une pluralité de structures de lignes de bits (30) réparties à intervalles sur le substrat, chacune des structures de lignes de bits (30) comprenant une couche conductrice (301), une couche de transition (302) et une couche de recouvrement (3031) empilées séquentiellement, et une largeur de la couche de transition (302) étant inférieure à une largeur de la couche conductrice (301), la couche conductrice (301) étant connectée à une structure active (20) d'une structure de transistor ;
des entrefers (305) situés sur une surface supérieure de la couche conductrice (301) et sur les surfaces latérales de la couche de transition (302) ;
des fiches conductrices (40) situées sur le substrat entre les structures de lignes de bits (30), chacune des fiches conductrices (40) comprenant une première partie conductrice (401) et une seconde partie conductrice (402) située au-dessus de la première partie conductrice (401), la fiche conductrice (40) étant configurée pour être connectée à une structure de stockage de condensateur,
**caractérisé en ce qu'**
une partie inférieure de la seconde partie conductrice (402) présente une surface inclinée (4021) faisant face à la structure de lignes de bits (30),
une distance verticale entre un coin supérieur de la couche de transition (302) et la surface inclinée (4021) est inférieure à une distance verticale entre un coin supérieur de la couche conductrice (301) et la surface inclinée,
une partie inférieure de la surface inclinée (4021) est plus haut qu'un haut de la couche conductrice (301) et plus bas qu'un haut de la couche de transition (302).

5. Structure DRAM de la revendication 4, dans laquelle une largeur de la couche de recouvrement (3031) est supérieure à une largeur de la couche conductrice (301).

6. Structure DRAM de la revendication 4, dans laquelle les entrefers (305) font saillie à partir des surfaces latérales de la couche conductrice (301).

7. Structure DRAM de la revendication 4, dans laquelle
la partie inférieure de la seconde partie conductrice (402) comprend en outre une surface inférieure (4024), une première surface droite (4022) et une seconde surface droite (4023), la surface inférieure (4024) étant en contact direct avec la première partie conductrice (401), et deux extrémités de la surface inférieure (4024) étant respectivement reliées à la première surface droite (4022) et à la seconde surface droite (4023) ; et
la première surface droite (4022) est également reliée à la surface inclinée (4021).

8. Structure DRAM de la revendication 4, dans laquelle une largeur de la couche de transition (302) est de 2/3 à 3/4 d'une largeur de la couche conductrice (301).

9. Structure DRAM de la revendication 4, dans laquelle un matériau de la couche de transition (302) comprend un nitrure riche en métal ou un siliciure riche en métal, un matériau de la couche de recouvrement (3031) comprend un nitrure de silicium, le nitrure riche en métal signifiant que le rapport molaire entre les atomes de métal et les atomes d'azote est supérieur à 1, et le siliciure riche en métal signifiant que le rapport molaire entre les atomes de métal et les atomes de silicium est supérieur à 1.
